# EUROPÄISCHE PATENTSCHRIFT

(11) **EP 2 158 624 B1**
(45) Veröffentlichungstag und Bekanntmachung des Hinweises auf die Patenterteilung: **08.01.2014**
(21) Anmeldenummer: 08761057.2
(22) Anmeldetag: 16.06.2008
(51) Int. Cl.: H01L 51/00

(54) **HALBLEITENDES MATERIAL UND ORGANISCHE GLEICHRICHTERDIODE**
SEMICONDUCTOR MATERIAL AND ORGANIC RECTIFIER DIODE
MATÉRIEL SEMI-CONDUCTEUR ET DIODE ORGANIQUE DE REDRESSEMENT

(30) Priorität: 20.06.2007 DE 102007028236
(43) Veröffentlichungstag der Anmeldung: 03.03.2010
(73) Patentinhaber: Siemens Aktiengesellschaft, 80333 München (DE)
(72) Erfinder: KRAUSE, Ralf, 91058 Erlangen (DE); SCHMID, Günter, 91334 Hemhofen (DE)
(86) Internationale Anmeldenummer: PCT/EP2008/057540
(87) Internationale Veröffentlichungsnummer: WO 2008/155310

(56) Entgegenhaltungen:
- EP-A- 1 289 030
- EP-A- 1 359 630
- EP-A- 1 860 709
- WO-A-2005/036667
- WO-A-2005/086251
- JP-A- 3 208 689
- US-A1- 2004 241 492
- YAMASHITA K ET AL: "FABRICATION OF AN ORGANIC P-N HOMOJUNCTION DIODE USING ELECTROCHEMICALLY CATION- AND PHOTOCHEMICALLY ANION-DOPED POLYMER" JAPANESE JOURNAL OF APPLIED PHYSICS, JAPAN SOCIETY OF APPLIED PHYSICS, TOKYO, JP, Bd. 34, Nr. 7B, 1. Juli 1995 (1995-07-01), Seiten 3794-3797, XP000703013 ISSN: 0021-4922
- F.A. COTTON, E.V. CIKAREV, M.A. PETRUKHINA, S.-E. STIRIBA: POLYHEDRON, Bd. 19, 2000, Seiten 1829-1835, XP002494592

## Beschreibung

Die Erfindung betrifft ein halbleitendes Material und eine organische Gleichrichterdiode, wie sie beispielsweise für organisch basierte RFID (Radio-Frequenz-Identifikations-Tags) zum Einsatz kommt.

Schaltkreise auf der Basis organischer Halbleiter sind von Interesse für eine Vielzahl elektronischer Anwendungen, die niedrige Fertigungskosten, flexible oder unzerbrechliche Substrate, oder die Herstellung von Bauelementen über große aktive Flächen erfordern. Zum Beispiel eignet sich die organische Elektronik für die Herstellung von extrem preiswerten integrierten Schaltungen, wie sie zum Beispiel für die aktive Kennzeichnung und Identifizierung von Waren und Gütern zum Einsatz kommen.

Passive RF-ID Systeme beziehen ihre Energie aus dem eingestrahlten Wechselfeld. Der mögliche Abstand zwischen Lesegerät und Transponder hängt dabei von der abgestrahlten Leistung und dem Energiebedarf des Transponders ab. Produkte, die einen siliziumbasierten Chip enthalten, sind für viele Anwendungen zu teuer. Beispielsweise kommt für die Kennzeichnung von Lebensmitteln (Preis, Verfallsdatum etc.) ein siliziumbasiertes Ident-Tag nicht in Betracht.

Polymere bzw. organische Halbleiter bieten anderseits das Potential, dass billige Drucktechniken zu ihrer Strukturierung und Applikation eingesetzt werden können.

Um die Trägerfrequenz des RFID-Systems zur Spannungsversorgung nutzbar zu machen, muss diese gleichgerichtet werden. Im einfachsten Fall wird dazu eine Diode (Halbwellgleichrichtung), für komplexere Anwendungen werden mehrere Dioden verwendet (2 Dioden: Vollwellenschaltung mit Mittelabgriff des Transformators; 4 Dioden: Graetzschaltung). Somit kann ein Gleichrichter nur eine einzelne Diode sein, mehrere Dioden umfassen und/oder zusätzlich einen Kondensator haben.

Aus der DE 10044842 ist ein organischer Gleichrichter, eine organisch basierte Schaltung, RFID-Tag und Verwendung eines organischen Gleichrichters bekannt. In dem dort beschriebenen organischen Gleichrichter wird zumindest eine der p/ndotierten leitfähigen Schichten einer herkömmlichen p/n-Halbleiter-Diode durch ein organisches leitfähiges Material ergänzt und/oder ersetzt. Ebenso kann bei einer herkömmlichen Metall/Halbleiter Diode (Schottky-Diode) zumindest eine Schicht durch eine organische Schicht ersetzt werden.

Der organische Gleichrichter besteht zumindest aus zwei Schichten, kann aber auch zur Optimierung weitere Schichten (z.B. zur Anpassung der Austrittsarbeit) umfassen. So kann z.B. eine undotierte halbleitende Schicht eingefügt werden, welche die Kapazität verringert und damit höhere Frequenzen ermöglicht.

Dabei ist das organische halbleitende Material an das leitende Material so angepasst, dass die Struktur des Gleichrichters bei Anlegen einer Spannung eine typische Diodenkennlinie ergibt, wobei der Strom nur in einer Richtung fließt und in der anderen Richtung weitgehend gesperrt ist.

Ein beispielhafter Aufbau einer Gleichrichterdiode umfasst eine erste elektrische Leitung, durch die Wechselstrom an die Kathode gelangt. Von der Kathode gelangen bei positiver Spannung Elektronen in das Leitermaterial und von dort in das organische halbleitende Material und durch die zweite Leitermaterialschicht an die Anode. Die zweite elektrische Leitung nimmt die Elektronen dann auf. Im Falle negativer Spannung schließt der Gleichrichter und das halbleitende Material sperrt den Stromfluss. Alternativ dazu gibt es die so genannte Schottky-Diode, die im einfachsten Fall nur eine Metallschicht und eine halbleitende Schicht umfasst.

Die US 2004/241492 A1 offenbart ein halbleitendes organisches Material für eine organische Diode, die p-dotiert ist mit einem Metallkomplex, der ein Übergangsmetallatom als Zentralatom hat.

K. Yamashita, Y. Kunugi, Y. Harima Jpn. J. Appl. Phys. 34, (1995) 3794-3797 beschreibt die p-Dotierung von Polymethylthiophen mit einem Rutheniumkomplex.

Die JP 03 208689 A beschreibt den Einsatz von Nickel-Dithiolat-Komplexen als Dotierungsmittel.

Aus der EP 1 289 030 A ist die Dotierung lochleitfähigerSchichten durch die oxidierte Form des lochleitfähigen Materials in organischen elektronischen Bauelementen bekannt.

Die WO 2005/036667 schlägt die Dotierung von organischem Halbleitermaterial mit Übergangsmetallkomplexen vor, wobei als Liganden verschiedene Pyrdidin, Quinolin- und/oder Cyanin-Derivate genannt werden.

In der EP 1 359 630 A ist das Problem behandelt, wie organische Binder in Lochtransportschichten vermieden werden können. Dazu werden verschiedene Systeme vorgeschlagen die der Lochtransportschicht zugesetzt werden, damit auf den Binder verzichtet werden kann. Es werden oxidationsmittel vorgeschlagen, beispielsweise die Anionen SbF6- oder ähnliche Anionen, nicht aber Carbonsäuren oder Carbonsäureanionen.

Die EP 1 860 709 A) offenbart die Verwendung eines qudratisch planaren Übergangsmetallkomplexes als Dotand, wobei Liganden mit Stickstoff oder Schwefelkoordination am Zentralatom vorgeschlagen werden.

Es besteht Bedarf an einem organischen halbleitenden Material, das in einem Diodenaufbau eine Diodenkennlinie ergibt und das gleichzeitig eine hohe Stromtragfähigkeit mit einer inhärenten Strombegrenzung zeigt.

Gegenstand der Erfindung ist ein halbleitendes organisches Material, das in einem Diodenaufbau eine Diodenkennlinie ergibt, wobei das Material zumindest eine lochleitende Matrix umfasst, in die ein Metallkomplex eingebettet ist, wobei der Metallkomplex dadurch gekennzeichnet ist, dass er ein Metallkomplex mit Lewissäureeigenschaft ist, weil die Liganden Carbonsäuren oder Carbonsäureanionen mit elektronenziehenden Substituenten sind.

Als Kathode oder Elektrode mit hoher Austrittsarbeit eignet sich beispielsweise Indium Zinn Oxid (ITO) und Gold sowie grundsätzlich alle Edelmetalle und Legierungen daraus. Anstelle von den genannten können aber auch andere Materialien mit hohen Austrittsarbeiten, Silber, Platin, Palladium (allgemein Edelmetalle) oder auch organische Leiter wie polystyrolsulfonsäuredotiertes Polydiethoxythiophen (PEDOT:PSS) oder dotiertes Polyanilin (PANI) Verwendung finden.

Als Anode oder Elektrode mit niedriger Austrittsarbeit eignen sich beispielsweise Aluminium, Magnesium sowie beliebige Legierungen und andere unedle Metalle. Neben Aluminium eigen sich andere unedle Metalle als 2. Elektrode, insbesondere Ti, Mo, Al-Mg-Legierungen, Ca, Lathanoide Sm, Y, Erdalkalimetalle Ca, Mg, Sr, Ba, sowie beliebige Mischungen und/oder Legierungen daraus.

Als lochleitende Matrix eignen sich viele bekannte lochleitende Materialien wie z. B. NPB; Naphdata; N,N'-Bis(naphthalen-1-yl)-N,N'-bis(phenyl)-benzidine; N,N'-Bis(naphthalen-2-yl)-N,N'-bis(phenyl)-benzidine; N,N'-Bis(3-methylphenyl)-N,N'-bis(phenyl)-benzidine; N,N'-Bis(3-methylphenyl)-N,N'-bis(phenyl)-9,9-spirobifluoxene; N,N'-Bis(naphthalen-1-yl)-N,N'-bis(phenyl)-9,9-spirobifluorene; N,N'-Bis(3-methylphenyl)-N,N'-bis(phenyl)-9,9-dimethyl-fluorene; N,N'-Bis(3-naphthalen-1-yl)-N,N'-bis(phenyl)-9,9-dimethyl-fluorene; N,N'-Bis(3-methylphenyl)-N,N'-bis(phenyl)-9,9-diphenyl-fluorene; N,N'-Bis(3-naphthalen-1-yl)-N,N'-bis(phenyl)-9,9-diphenyl-fluorene; 2,2',7,7'-Tetrakis(N,N-diphenylamino)-9,9'-spirobifluorene; 9,9-Bis[4-(N,N-bis-biphenyl-4-yl-amino)phenyl]-9H-fluorene; 9,9-Bis[4-(N,N-bis-naphthalen-2-yl-amino)phenyl]-9H-fluorene; 9,9-Bis[4-(N,N'-bis-naphthalen-2-yl-N,N'-bis-phenyl-amino)-phenyl]-9H-fluorene; 2,2',7,7'-Tetrakis[(N-naphthalenyl(phenyl)-amino]-9,9-spirobifluorene; N,N'-bis(phenanthren-9-yl)-N,N'-bis(phenyl)-benzidine; 2,7-Bis[N,N-bis(9,9-spiro-bifluorene-2-yl)-amino]-9,9-spirobifluorene; 2,2'-Bis[N,N-bis(biphenyl-4-yl)amino]-9,9-spirobifluorene; 2,2'-Bis(N,N-di-phenyl-amino)-9,9-spirobifluorene; Phthalocyanine-Coppercomplex; 4,4',4"-Tris(N-3-methylphenyl-N-phenyl-amino)triphenylamine: 4,4',4"-Tris(N-(2-naphthyl)-N-phenyl-amino)triphenylamine; 4,4',4''-Tris(N-(1-naphthyl)-N-phenyl-amino)triphenylamine; 4,4',4 "-Tris(N,N-diphenyl-amino)triphenylamine; Titanium oxide phthalocyanine; 2,3,5,6-Tetrafluoro-7,7,8,8,-tetracyano-quinodimethane; Pyrazino[2,3-f][1,10]phenanthrolone-2,3-dicarbonitrile; N,N,N',N'-Tetrakis(4-methoxyphenyl)benzidine: 2,7-Bis[N,N-bis(4-methoxy-phenyl)amino]-9,9-spirobifluorene; 2,2'-Bis[N,N-bis(4-methoxy-phenyl)amino]-9,9-spirobifluorene; 1,3-Bis(carbazol-9-yl)benzene; 1,3,5-Tris(carbazol-9-yl)benzene; 4,4',4"-Tris(carbazol-9-yl)triphenylamine; 4,4'-Bis(carbazol-9-yl)biphenyl; 4,4'-Bis(9- carbazolyl)-2,2'-dimethyl-biphenyl; 2,7-Bis(carbazol-9-yl)-9,9-dimentylfluorene und 2,2',7,7'-Tetrakis(carbazol-9-yl)-9,9'-spirobifluorene.

Besonders bevorzugt als Dopant ist das Dirhodiumtetratrifluoracetat, das sich aufgrund seiner günstigen Sublimationseigenschaften sehr gut für eine Vakuumdeposition eignet. In der chemischen Literatur konnte unerwarteter Weise auch kristallografisch gezeigt werden, dass sogar unsubstituierte Aromaten als Donor für den Rh₂⁴⁺-Kern in axialer Position dienen können und somit durch Ladungsabzug eine p-Dotierung zu bewirken.

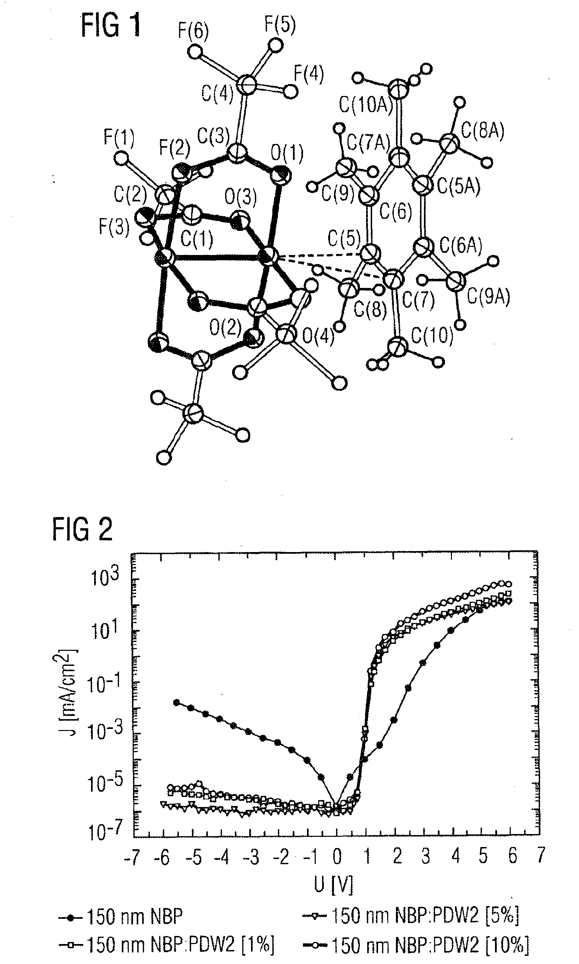

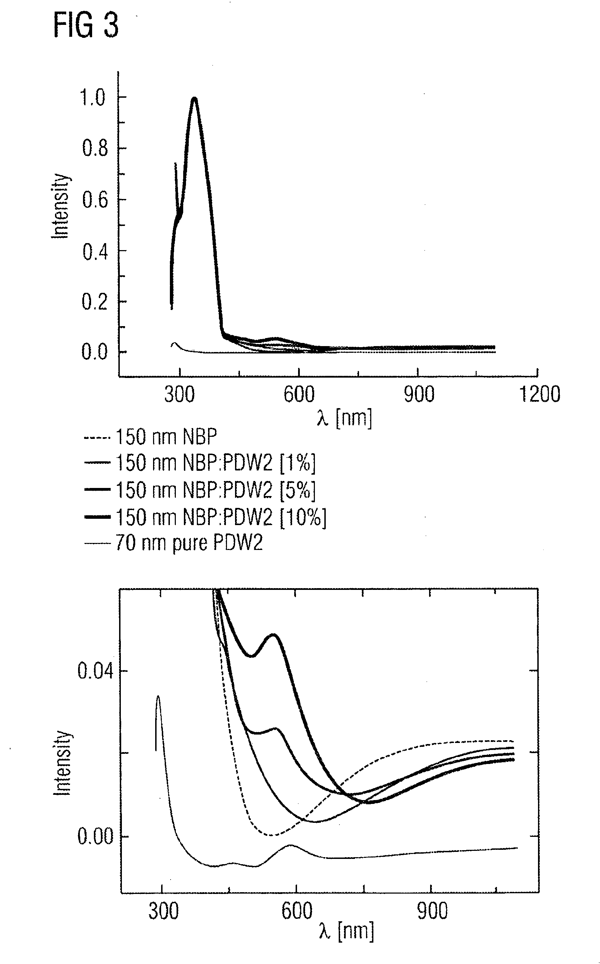

Die Figur 1 zeigt eine röntgenkristallographisch aufgenommene Struktur eines Kristalls dieser Verbindung, bei der das Rh₂(CF₃COO)₄ an das aromatische System Hexamethylbenzol koordiniert.

Auch die isoelektronischen Metallkomplexe dieser Struktur, insbesondere solche, die noch ähnliche Größen zeigen wie beispielsweise ein Analogon mit Ru₂²⁺-Ionen als Zentralatomen sind ebenfalls geeignet als p-Dotanden für die lochleitende Matrix gemäß der Erfindung. Die bewirkt zum einen die Schaufelradstruktur und zum anderen die sehr hohe Lewis-Säure Azidität dieser Komplexe. Insbesondere geeignet sind die, die an aromatische Systeme koordinieren können.

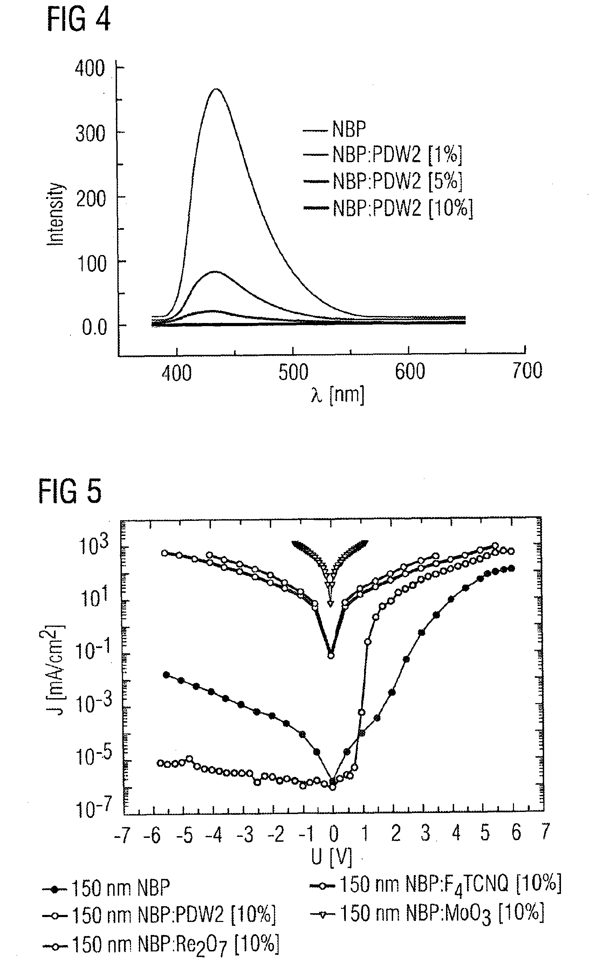

Bei einem so genannten Schaufelradkomplex oder paddle-whell-Komplex sind zwei Metallzentralatome insbesondere Übergangsmetallatome, durch bevorzugt 2, möglicherweise aber auch 3, 4 oder mehrzähnige Liganden, die an beide Metallzentralatome jeweils ein Ligandenatom binden, überbrückt. Die Metallatome sind hierbei, je nach Radius, zumeist 4-fach oder auch 5-fach oder höher koordiniert, wobei der Lewissäurecharakter eben auch dadurch gegeben ist, dass zumindest eine lockere oder leere Koordinationsstelle, an der beispielsweise die Anlagerung eines aromatischen Ringes, wie in Figur 4 gezeigt, stattfinden kann, vorhanden ist. Die Koordinationsumgebung des Metallatoms ist bevorzugt so, dass eine Metall - Metall Bindung besteht, 4 equatoriale Bindungen und eine axiale Bindung, die je nach Ligand und Zentralatom Lewis-azid ist.

Als Liganden eignen sich grundsätzlich alle zwei -oder mehrzähnigen, bevorzugt elektronenziehende Liganden. Beispielsweise genannt seien die Anionen von elektronenziehenden Carbonsäuren, wie beispielsweise CHalₓH₃₋ₓCOOH, insbes. CFₓH₃-ₓCOOH und CClₓH₃₋ₓCOOH, (CR₁, R₂, R₃) COOH, wobei R1, R2 und R3 unabhängig voneinander Alkyl wie, besonders bevorzugt, H, methyl, ethyl, propyl, isopropyl; n-, sec-, tert-Butyl, Benzoesäure und deren substituierten Analoga (o, p, m-Fluorbenzoesäure, o,p,m- Cyanobenzoesäure, Nitrobenzoesäure, Alkylbenzoesäuren fluoriert oder teilweise fluoriert, ggf. auch ein oder mehrfach substituiert, Pyridincarbonsäuren etc.) sein kann.

Die erfindungsgemäß verwendeten Metallkomplexe stellen vorzugsweise Moleküle dar, die unabhängig voneinander verdampfbar sind. Dabei versteht sich, dass einzelne Metallkomplexe jeweils untereinander oder mit anderen Komponenten wie dem Matrixmaterial gebunden sein können.

Rein formal könnten die Valenzelektronen des PDW-2 wie folgt berechnet werden:
In der Gruppe IX mit 4 einfach negativ geladenen zweizähnigen Liganden ergibt sich folgendes Bild für Metall-Metall:
   4 x 4e = 16 Elektronen von den Liganden
   1 x 2e = 8 von der Einfachfachbindung zwischen Rh-Rh
   2 x 9e = 12 vom Rhodium

Summe 36, damit hat jedes Rh Edelgaskonfiguration d.h. stabil Oder:
Gruppe 6: Metall - Metall-Vierfachbindung d.h. σ, 2 x π, 1 x δ-Bindung besetzt
Gruppe 7: Metall - Metall-Dreifachbindung d.h. σ, 2 x π, 1 x δ-Bindung, 1 x δ* besetzt
Gruppe 8: Metall - Metall-Zweifachbindung d.h. σ, 2 x π, 1 x δ-Bindung, 1 x δ*, 1 x π* besetzt
Gruppe 8: Metall - Metall-Zweifachbindung d.h. σ, 2 x π, 1 x δ-Bindung, 1 x δ*, 1 x π* besetzt
Gruppe 9: Metall - Metall-Einfachbindung d.h. σ, 2 x π, 1 x δ-bindung, 1 x δ*, 2 x π* besetzt

Dabei versteht sich, dass einzelne Metallkomplexe jeweils untereinander oder mit anderen Komponenten wie dem Matrixmaterial gebunden sein können. Durch die Bindungsbildung der Donator-Akzeptorwechselwirkung und die Molekülgröße werden die Dopanten in der Matrix fixiert.

Die experimentell gefundene Strombegrenzung wurde bisher bei keiner der publizierten für die Dotierung geeigneten Materialsysteme beobachtet. Für RFID-Anwendungen ist diese Schicht von Vorteil, da im Nahfeld des Sender der Schaltkreis nicht übermäßig belastet wird, da die inhärente Strombegrenzung wirkt.

Die Stromtragfähigkeit von organischen Schottky-Dioden wird durch die Verwendung einer dotierten Halbleiterschicht um mehrere Großenordnungen erhöht. Stand der Technik sind undotierte Systeme. Die vorgestellte Materialkombination zeigt zudem unerwartet eine inhärente Strombegrenzung.

Im Folgenden wird die Erfindung noch anhand von Beispielen näher erläutert:

### Beispiel 1:

Auf einer ITO (Indium-tin-oxide = indiumdotiertes Zinnoxid) Elektrode wurde durch thermisches Verdampfen eine 150 nm dicke Schicht des Eleketronenleiters NPB (= Bis-N,N,N',N'-(naphthyl-phenyl) benzidin) abgeschieden. Als Gelegenelektroden diente eine 150 nm dicke Aluminiumschicht. Ein 4 mm² großes Bauelement ergab die durch schwarze,Kreise markierte typische Kennlinie, wie sie in Figur 2 gezeigt ist.

In einem zweiten Experiment wird PDW-2 (= Dirhodiumtetrafluoracetat) durch Koverdampfung in den Lochleiter NPB (= Bis-N,N,N',N'-(naphthyl-phenyl)benzidin) eindotiert. Für eine Dotierung von 0% (schwarz), 1% (rot), 5% (grün) und 10% (blau) ergaben sich die ebenfalls in Figur 2 dargestellten Kennlinien.

Diese demonstrieren eindeutig die Möglichkeit zur Dotierung von lochleitenden Matrixmaterialien durch PDW-2. Erstaunlicherweise können aus Aluminium keine Löcher injiziert werden (negativer Ast der x-Achse), wodurch sich ein Gleichrichtungsfaktor von 3·10⁻⁷ ergibt. Für eine effektive Dotierung reichen nur wenige Schichtdicken-% aus. Die Kennlinien zwischen 1 - 10% PDW-2 in NPB sind nahezu identisch. Die Kennlinien sind zudem sehr steil. Bei höheren Spannungen sättigt die Kennlinie, wodurch ein strombegrenzendes Verhalten resultiert.

### Beispiel 2:

Eine zusätzliche Bande im UV-Spektrum im Bereich zwischen 550-600 nm zeigt die Dotierfähigkeit von NPB durch PDW-2

### Beispiel 3:

Figur 4 zeigt das Photolumineszenzspektrum der in Beispiel 3 dargestellten Schichten. Bei Anregung der Schicht mit UV-Licht von 342 nm nimmt die Fluoreszenz der NPB Schicht stetig ab. Ganz im Einklang zu anderen Dotanten löscht auch PDW-2 die Fluoreszenz.

### Beispiel 4:

Andere literaturbekannte Dopanden z.B. MoO₃, F₄TCNQ., Re₂O₇ zeigen in der gleichen Anordnung keine gleichrichtende Wirkung, wie Figur 5 belegt..

### Beispiel 5:

Die Ladungsträgerdichte kann in anderen Lochleitern wie Naphdata durch den Dopanden PDW-2 ebenfalls erhöht werden (Naphdata =4,4',4"-Tris((N-naphthyl)-N-phenyl-amino)-triphenylamin).

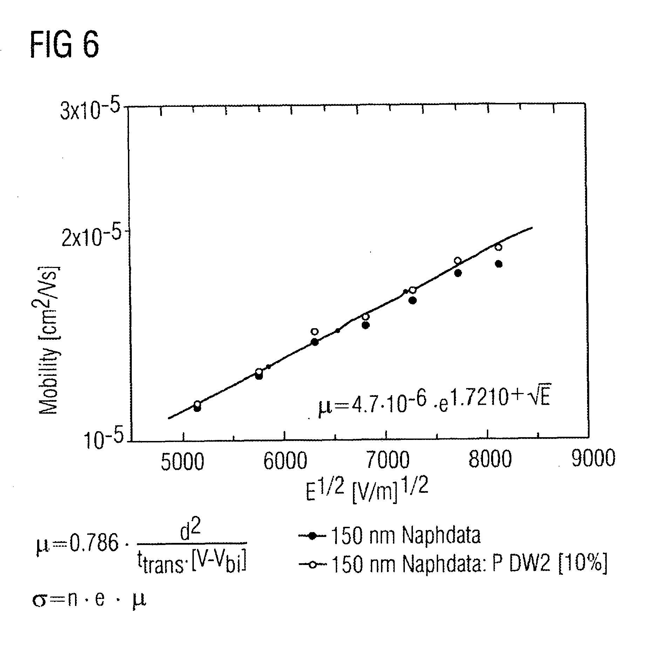

Transiente Dunkelstrommessungen zeigen, dass bei einer Dotierung von 10% PDW-2 in Naphdata die Mobilität nahezu konstant bleibt. Wie Figur 6 demonstriert steigt die für die organische Leuchtdiode zur Verfügung stehende Ladungsträgerdichte stark an, was sich sehr positiv auf die Kennlinien von organischen Leuchtdioden auswirkt. ( 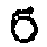 = Leitfähigkeit, µ = Mobilität, n = Zahl der Ladungsträger, e = Elementarladung)

Die Erfindung zeichnet sich insbesondere dadurch aus, dass die verwendeten Materialien zu den Basismaterialien organischer elektronischer Bauteile kompatibel sind und dass beispielsweise in den bevorzugten zweikernigen Metallkomplexen mit der Metall-Metallbindung formal die Ladung beim Stromtransport im Molekül auf zwei Metallatome verteilt wird, was zur Stabilität der Gesamtschicht beiträgt.

Die Erfindung betrifft ein halbleitendes Material und eine organische Gleichrichterdiode, wie sie beispielsweise für organisch basierte RFID (Radio-Frequenz-Identifikations-Tags) zum Einsatz kommt.

## Patentansprüche

1. Halbleitendes Material für eine organische Diode umfassend einen Metallkomplex als p-Dotand zur Dotierung eines lochleitenden organischen Matrixmaterials,
**dadurch gekennzeichnet, dass** der Metallkomplex ein Metallkomplex mit Lewissäureeigenschaft ist, der als Elektronenpaarakzeptor wirkt, weil die Liganden Carbonsäuren oder Carbonsäureanionen mit elektronenziehenden Substituenten sind.

2. Halbleitendes Material nach Anspruch 1, wobei der Metallkomplex ein mehrkerniger Metallkomplex ist.

3. Halbleitendes Material nach einem der vorstehenden Ansprüche 1 oder 2, wobei das Zentralatom des Metallkomplexes ein neutrales oder geladenes Übergangsmetallatom ist.

4. Halbleitendes Material nach einem der vorstehenden Ansprüche, wobei zumindest ein Zentralatom des Metallkomplexes aus der Platingruppe, folgende Elemente umfassend: Ruthenium, Rhodium, Palladium, Osmium, Iridium und Platin ausgewählt ist.

5. Halbleitendes Material nach einem der vorstehenden Ansprüche, wobei zumindest ein Zentralatom des Metallkomplexes Rhodium ist.

6. Halbleitendes Material nach einem der vorstehenden Ansprüche, wobei der Metallkomplex ein mehrkerniger Metallkomplex ist, bei dem zumindest ein Ligand zwei Zentralatome koordinativ verbindet.

7. Halbleitendes Material nach einem der vorstehenden Ansprüche, wobei zumindest ein Zentralatom quadratisch planar von Liganden umgeben ist.

8. Halbleitendes Material nach einem der vorstehenden Ansprüche, wobei der Metallkomplex mehrkernig und symmetrisch aufgebaut ist.

9. Halbleitendes Material nach einem der vorstehenden Ansprüche, wobei zumindest ein Metallkomplex eine Schaufelradstruktur hat.

10. Halbleitendes Material nach Anspruch 9, wobei das molare Dotierungsverhältnis von p-Dotand zu monomeren Einheiten eines polymeren lochleitenden Matrixmoleküls zwischen 1:1 und 1:100.000 beträgt.

11. Organische Gleichrichterdiode, einen elektronisch funktionell wirksamen halbleitenden Bereich umfassend, wobei der elektronisch funktionell wirksame Bereich unter Verwendung zumindest eines oder mehrerer halbleitenden Materialien nach einem der Ansprüche 1 bis 10 hergestellt ist.

12. Organische Gleichrichterdiode nach Anspruch 11, die Teil einer organischen integrierten Schaltung ist.

## Claims

1. Semiconducting material for an organic diode comprising a metal complex as a p-dopant for doping a hole-conducting organic matrix material,
**characterised in that** the metal complex is a metal complex with Lewis acid properties, which acts as an electron pair acceptor, because the ligands are carboxylic acids or carboxylic acid anions with electron-attracting substituents.

2. Semiconducting material according to claim 1, with the metal complex being a multi-core metal complex.

3. Semiconducting material according to one of the preceding claims 1 or 2, with the central atom of the metal complex being a neutral or charged transition metal atom.

4. Semiconducting material according to one of the preceding claims, with at least one central atom of the metal complex being chosen from the platinum group containing the following elements: ruthenium, rhodium, palladium, osmium, iridium and platinum.

5. Semiconducting material according to one of the preceding claims, with at least one central atom of the metal complex being rhodium.

6. Semiconducting material according to one of the preceding claims, with the metal complex being a multi-core metal complex, with which at least one ligand coordinatively connects two central atoms.

7. Semiconducting material according to one of the preceding claims, with at least one central atom being surrounded, in a quadratic planar fashion, by ligands.

8. Semiconducting material according to one of the preceding claims, with the metal complex being of multi-core, symmetrical construction.

9. Semiconducting material according to one of the preceding claims, with at least one metal complex having a paddlewheel structure.

10. Semiconducting material according to claim 9, with the molar doping ratio of p-dopant to monomer units of a polymer hole-conducting matrix molecule being between 1:1 and 1:100,000.

11. Organic rectifier diode, comprising an electronic functionally effective semiconducting area, with the electronic, functionally effective area being produced using at least one or more semiconducting materials according to one of claims 1 to 10.

12. Organic rectifier diode according to claim 11, which is part of an organic integrated circuit.

## Revendications

1. Matériau semi-conducteur pour une diode organique, comprenant un complexe métallique comme dopant p pour le dopage d'un matériau matriciel organique conducteur à trous,
**caractérisé en ce que** le complexe métallique est un complexe métallique présentant une propriété d'acide de Lewis qui agit en tant qu'accepteur de paires d'électrons parce que les ligands sont des acides carboniques ou des anions d'acide carbonique possédant des substituants attirant les électrons.

2. Matériau semi-conducteur selon la revendication 1, le complexe métallique étant un complexe métallique à plusieurs noyaux.

3. Matériau semi-conducteur selon l'une des revendications précédentes 1 ou 2, l'atome central du complexe métallique étant un atome de métal de transition neutre ou chargé.

4. Matériau semi-conducteur selon l'une des revendications précédentes, au moins un atome central du complexe métallique étant choisi dans le groupe des platines comprenant les éléments suivants : ruthénium, rhodium, palladium, osmium, iridium et platine.

5. Matériau semi-conducteur selon l'une des revendications précédentes, au moins un atome central du complexe métallique étant le rhodium.

6. Matériau semi-conducteur selon l'une des revendications précédentes, le complexe métallique étant un complexe métallique à plusieurs noyaux dans lequel au moins un ligand forme une liaison de coordination entre deux atomes centraux.

7. Matériau semi-conducteur selon l'une des revendications précédentes, au moins un atome central étant entouré de ligands en plan carré.

8. Matériau semi-conducteur selon l'une des revendications précédentes, le complexe métallique ayant une structure symétrique à plusieurs noyaux.

9. Matériau semi-conducteur selon l'une des revendications précédentes, au moins un complexe métallique ayant une structure en roue à aubes.

10. Matériau semi-conducteur selon la revendication 9, le rapport molaire de dopage de l'agent dopant p sur les unités monomères d'une molécule de matrice polymère conductrice à trous étant compris entre 1:1 et 1:100.000.

11. Diode organique de redressement, comprenant une zone semi-conductrice électriquement et fonctionnellement active, la zone électriquement et fonctionnellement active étant fabriquée en utilisant au moins un ou plusieurs matériaux semi-conducteurs selon l'une des revendications 1 à 10.

12. Diode organique de redressement selon la revendication 11, qui fait partie d'un circuit intégré organique.
